# EUROPÄISCHE PATENTSCHRIFT

(11) **EP 4 066 605 B1**
(45) Veröffentlichungstag und Bekanntmachung des Hinweises auf die Patenterteilung: **25.02.2026**
(21) Anmeldenummer: 20812280.4
(22) Anmeldetag: 24.11.2020
(51) Int. Cl.: H05K 7/20

(54) **STROMRICHTER**
POWER CONVERTER
CONVERTISSEUR ÉLECTRIQUE

(30) Priorität: 25.11.2019 DE 102019218207
(43) Veröffentlichungstag der Anmeldung: 05.10.2022
(73) Patentinhaber: Lenze Swiss AG, 8590 Romanshorn (CH)
(72) Erfinder: BURGERMEISTER, Andreas, 8576 Mauren (CH); HEIM, Beat, 9225 Wilen (CH); TANNER, Dieter, 8581 Schocherswil (CH)
(74) Vertreter: Patentanwälte Ruff, Wilhelm, Beier, Dauster & Partner mbB
(86) Internationale Anmeldenummer: PCT/EP2020/083212
(87) Internationale Veröffentlichungsnummer: WO 2021/105124

(56) Entgegenhaltungen:
- DE-A1- 102007 043 536
- DE-A1- 102007 057 471
- US-A1- 2015 116 937

## Beschreibung

Die Erfindung betrifft einen Stromrichter.

Die US 2015/0116937 A1 offenbart einen Stromrichter, aufweisend: eine erste Leiterplatte, einen Kühlkörper, ein Gehäuse, wobei der Kühlkörper und das Gehäuse die erste Leiterplatte umgeben, ein wärmeerzeugendes Bauelement, das wärmeleitend mit dem Kühlkörper gekoppelt ist, und weitere Bauelemente.

Die DE 10 2007 043 536 A1 offenbart ein Steuergerät eines Fahrzeugs, das mindestens drei elektrische Module mit unterschiedlichen Funktionen aufweist. Die Module sind in einem Gehäuse angeordnet.

Die DE 10 2007 057 471 A1 offenbart einen Kühlkörper, der verhindern soll, dass eine Geschwindigkeit von zwischen Rippen in der Nähe eines Komponentenmontageraums fließender Luft abnimmt.

Der Erfindung liegt die Aufgabe zugrunde, einen Stromrichter zur Verfügung zu stellen, der einfach und kostengünstig herstellbar ist und der eine wirksame Kühlung sämtlicher Stromrichter-Komponenten ermöglicht.

Der Stromrichter weist eine erste Leiterplatte auf.

Der Stromrichter weist weiter einen Kühlkörper auf.

Der Stromrichter weist weiter ein Gehäuse auf, wobei der Kühlkörper und das Gehäuse die erste Leiterplatte umgeben.

Der Stromrichter weist weiter ein wärmeerzeugendes Bauelement auf, das auf einer Seite der ersten Leiterplatte angeordnet ist, die dem Kühlkörper zugewandt ist und das wärmeleitend mit dem Kühlkörper gekoppelt ist. Das wärmeerzeugende Bauelement kann beispielsweise ein Leistungshalbleitermodul mit mehreren IGBTs sein, die beispielsweise einen 3-brückigen Wechselrichter bilden. Das wärmeerzeugende Bauelement kann beispielsweise auch ein DC/DC-Wandler mit Leistungshalbleitern sein, usw.

Der Stromrichter weist weitere herkömmliche Bauelemente auf, beispielsweise Kondensatoren, Widerstände, Drosseln, ICs, Mikrocontroller, usw. Die weiteren Bauelemente erzeugen bevorzugt im Betrieb weniger Wärme als das wärmeerzeugende Bauelement.

Der Kühlkörper, das Gehäuse und die erste Leiterplatte bilden bzw. begrenzen ein erstes Volumen bzw. einen ersten Raum, in dem das wärmeerzeugende Bauelement angeordnet ist.

Der Kühlkörper, das Gehäuse und die erste Leiterplatte bilden bzw. begrenzen gleichzeitig auch ein zweites Volumen bzw. einen zweiten Raum, in dem die weiteren Bauelemente, thermisch abgegrenzt vom ersten Volumen angeordnet sind.

Der Stromrichter weist einen herkömmlichen Lüfter auf, der im zweiten Volumen angeordnet ist und der eine Luftzirkulation im Wesentlichen ausschließlich im zweiten Volumen erzeugt.

Gemäß einer Ausführungsform sind der Kühlkörper, das Gehäuse und die erste Leiterplatte derart geometrisch ausgestaltet, dass die Luftzirkulation im zweiten Volumen größer ist, insbesondere mehr als 10 Mal größer ist, als eine Luftzirkulation im ersten Volumen. Dadurch wird insbesondere verhindert, dass ein schneller Luftaustausch zwischen den beiden Volumina stattfindet, sodass die Abwärme des wärmeerzeugenden Bauelements möglichst nicht in das zweite Volumen mittels Luftzirkulation eindringt.

Gemäß einer Ausführungsform ist das Gehäuse derart ausgestaltet, dass der Lüfter eine Luftzirkulation ausschließlich innerhalb des Gehäuses bewirkt. Insbesondere ist das Gehäuse derart ausgestaltet, dass ein Luftaustausch zwischen Innerem des Gehäuses und Gehäuseumgebung im Wesentlichen verhindert wird.

Gemäß einer Ausführungsform ist der Lüfter ein Axiallüfter mit einem Axiallaufrad, dessen Drehachse parallel zur ersten Leiterplatte verläuft.

Gemäß einer Ausführungsform weist der Stromrichter eine zweite Leiterplatte auf, die planparallel zur ersten Leiterplatte ausgerichtet ist. Der Lüfter kann zwischen der ersten und zweiten Leiterplatte angeordnet sein. Der Lüfter kann derart ausgebildet sein, dass er einen Luftstrom im Wesentlichen um die zweite Leiterplatte herum erzeugt. Die zweite Leiterplatte kann (ausschließlich) im zweiten Volumen angeordnet sein. Die erste oder die zweite Leiterplatte kann einen Leiterplattensteckverbinder aufweisen, der zum Anschließen des Lüfters dient. Die zweite Leiterplatte kann einen weiteren Leiterplattensteckverbinder aufweisen, der zur Verbindung mit einer Steuereinheit dient, die außerhalb des Gehäuses angeordnet ist.

Gemäß einer Ausführungsform weist der Stromrichter ein Halteelement auf, insbesondere ein Kunststoffformteil, wobei das Halteelement den Lüfter und die zweite Leiterplatte hält bzw. mechanisch fixiert bzw. trägt, wobei das Halteelement beispielsweise auf der ersten Leiterplatte abgestützt ist.

Gemäß einer Ausführungsform ist das Halteelement derart geometrisch ausgestaltet, dass ein mittels des Lüfters erzeugter Luftstrom, insbesondere ausschließlich, in das zweite Volumen geführt wird.

Gemäß einer Ausführungsform weist der Kühlkörper nur auf einer Seite, die dem wärmeerzeugenden Bauelement abgewandt ist, d.h. auf einer Gehäuseaußenseite, Kühlrippen auf.

Gemäß einer Ausführungsform weist der Stromrichter eine Schutzart gemäß IP 66 oder höher gemäß IEC 60 529 (EN 60 529) auf.

Gemäß einer Ausführungsform ist der Stromrichter eine Netzrückspeiseeinheit oder ein Frequenzumrichter. Eine Netzrückspeiseeinheit speist elektrische Energie/Leistung, die beispielsweise in einem Zwischenkreis vorhanden ist, in ein Versorgungsnetz zurück. Im Übrigen sei auch auf die einschlägige Fachliteratur verwiesen.

Die Erfindung wird nachfolgend unter Bezugnahme auf die Zeichnungen detailliert beschrieben.

Hierbei zeigt:
- Fig. 1: hoch schematisch einen Querschnitt eines erfindungsgemäßen Stromrichters,
- Fig. 2: hoch schematisch einen Querschnitt eines erfindungsgemäßen Stromrichters mit weiteren Komponenten,
- Fig. 3: eine detailliertere perspektivische Ansicht des teilweise geöffneten erfindungsgemäßen Stromrichters und
- Fig. 4: eine weitere perspektivische Ansicht in ein Gehäuseinneres des erfindungsgemäßen Stromrichters.

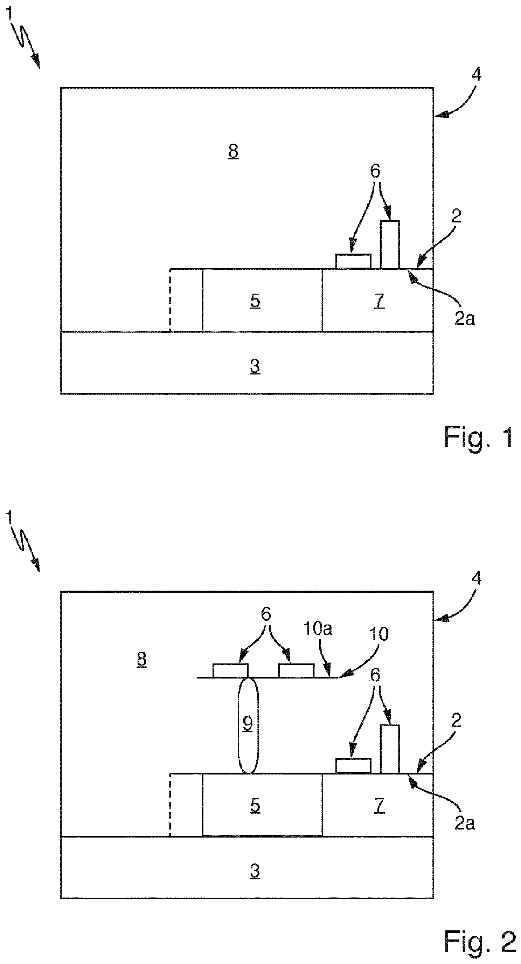

Fig. 1 zeigt hoch schematisch einen Querschnitt eines erfindungsgemäßen Stromrichters 1, beispielsweise in Form eines Frequenzumrichters oder einer Netzrückspeiseeinheit.

Der Stromrichter 1 weist eine erste Leiterplatte 2 auf.

Der Stromrichter 1 weist weiter einen als Gussteil ausgeführten Kühlkörper 3 auf. Der Kühlkörper 3 weist Befestigungselemente zur Befestigung an einem vorgesehenen Einbauort, beispielsweise einer Wand, auf.

Der Stromrichter 1 weist weiter ein Gehäuse 4 auf, wobei der Kühlkörper 3 und das Gehäuse 4 die erste Leiterplatte 2 umgeben.

Der Stromrichter 1 weist weiter ein wärmeerzeugendes Bauelement 5 auf, das auf einer Seite 2a der ersten Leiterplatte 2 angeordnet ist, die dem Kühlkörper 3 zugewandt ist und das wärmeleitend mit dem Kühlkörper 3 zur Wärmeabfuhr in eine Umgebung des Gehäuses 4 gekoppelt ist.

Das wärmeerzeugende Bauelement 5 ist auf der ersten Leiterplatte 2 elektrisch kontaktiert. Auf der ersten Leiterplatte 2 können weitere, nicht dargestellte Bauelemente angeordnet bzw. elektrisch kontaktiert sein, beispielsweise Kondensatoren, insbesondere Zwischenkreiskondensatoren, und weitere zu einem Zwischenkreis gehörende Bauelemente.

Der Stromrichter 1 weist eine Vielzahl von herkömmlichen weiteren Bauelementen 6 auf.

Der Kühlkörper 3, das Gehäuse 4 und die erste Leiterplatte 2 begrenzen ein erstes Volumen 7, in dem das wärmeerzeugende Bauelement 5 angeordnet ist.

Der Kühlkörper 3, das Gehäuse 4 und die erste Leiterplatte 2 begrenzen auch ein zweites Volumen 8, in dem die weiteren Bauelemente 6 angeordnet sind.

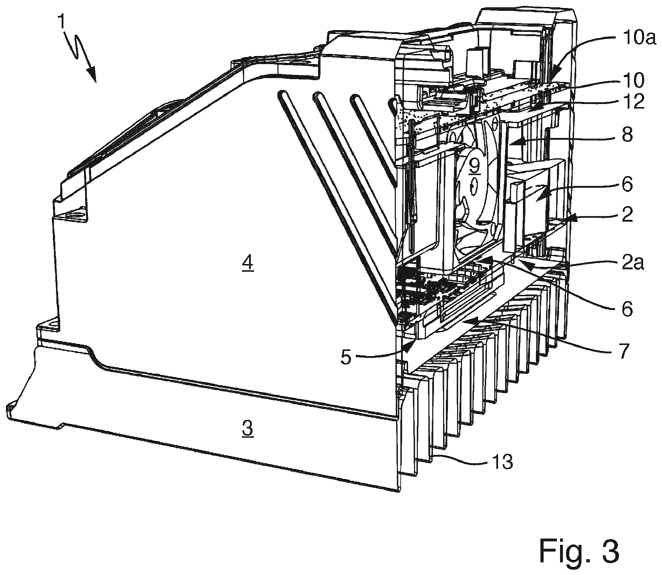

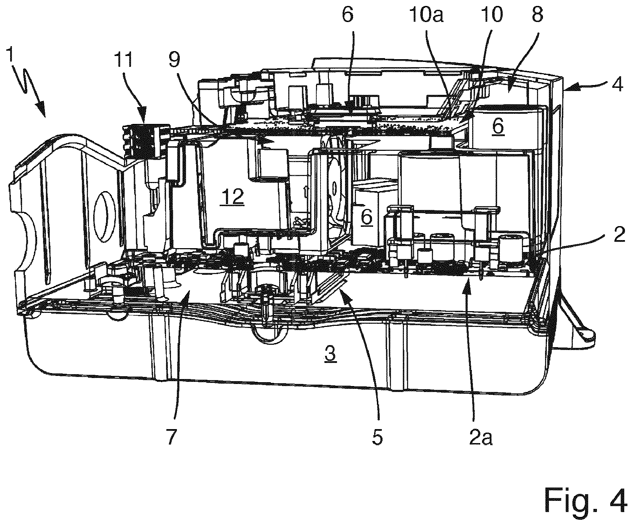

Nun Bezug nehmend auf die Figuren 2 bis 4 weist der Stromrichter 1 weiter einen Axiallüfter 9 auf, der im zweiten Volumen 8 angeordnet. Eine Drehachse des Axiallüfters 9 verläuft parallel zur ersten Leiterplatte 2.

Der Stromrichter 1 weist weiter eine zweite Leiterplatte 10 mit einer Bestückungsseite 10a auf, wobei auf der Bestückungsseite 10a weitere Bauelemente 6 angeordnet sind. Die zweite Leiterplatte 10 ist planparallel zur ersten Leiterplatte 2 ausgerichtet. Die Bestückungsseite 10a ist diejenige Leiterplattenseite, die von dem wärmeerzeugenden Bauelement 5 am weitesten entfernt ist. Auf der Bestückungsseite 10a sind folglich besonders wärmeempfindliche Bauelemente angeordnet, wie beispielsweise eine wärmeempfindliche Steuerelektronik.

Auf der zweiten Leiterplatte 10 kann eine nicht dargestellte Steuereinheit angeordnet sein, beispielsweise in Form eines Mikroprozessors, die bzw. der Steuersignale für das Bauelement 5 erzeugt.

Der Stromrichter 1 weist weiter ein Halteelement 12 in Form eines Kunststoffformteils auf, wobei das Halteelement 12 den Lüfter 9 und die zweite Leiterplatte 10 hält.

Das Halteelement 12, der Kühlkörper 3, das Gehäuse 4, die erste Leiterplatte 2 und die zweite Leiterplatte 10 sind derart geometrisch ausgestaltet und relativ zueinander angeordnet, dass ein mittels des Lüfters 9 erzeugter Luftstrom im Wesentlichen ausschließlich in das zweite Volumen 8 geführt wird, so dass eine Luftzirkulation im zweiten Volumen 8 wesentlich größer ist als eine Luftzirkulation im ersten Volumen 7.

Der Kühlkörper 3 weist nur auf einer Seite, die dem wärmeerzeugenden Bauelement 5 abgewandt ist, Kühlrippen 13 auf.

Der Stromrichter 1 weist eine Schutzart gemäß IP 66 auf.

Aufgrund der Trennung des ersten Volumens 7 von dem zweiten Volumen 8 wird ein Wärmeeintrag von dem ersten wärmeerzeugenden Bauelement 5, das im ersten Volumen 7 angeordnet ist, in Richtung der weiteren Bauelemente 6 reduziert, die thermisch getrennt vom wärmeerzeugenden Bauelement 5 im zweiten Volumen 8 angeordnet sind.

Die Wärmeabfuhr vom wärmeerzeugenden Bauelement 5 erfolgt im Wesentlichen nach Außen und nicht in das Gehäuseinnere. Eine Kühlung der weiteren Bauelemente 6 erfolgt im Wesentlichen durch Luftzirkulation im zweiten Volumen 8 und Wärmeabfuhr über den Bereich des Kühlkörpers 3, der an das zweite Volumen 8 angrenzt.

## Patentansprüche

1. Stromrichter (1), aufweisend:
- eine erste Leiterplatte (2),
- einen Kühlkörper (3),
- ein Gehäuse (4), wobei der Kühlkörper (3) und das Gehäuse (4) die erste Leiterplatte (2) umgeben,
- ein wärmeerzeugendes Bauelement (5), das auf einer Seite (2a) der ersten Leiterplatte (2) angeordnet ist, die dem Kühlkörper (3) zugewandt ist und das wärmeleitend mit dem Kühlkörper (3) gekoppelt ist, und
- weitere Bauelemente (6), die auf einer Seite der ersten Leiterplatte (2) angeordnet sind, die dem Kühlkörper (3) abgewandt ist,
- wobei der Kühlkörper (3), das Gehäuse (4) und die erste Leiterplatte (2) ein erstes Volumen (7) begrenzen, in dem das wärmeerzeugende Bauelement (5) angeordnet ist,
- wobei der Kühlkörper (3), das Gehäuse (4) und die erste Leiterplatte (2) ein zweites Volumen (8) begrenzen, in dem die weiteren Bauelemente (6) angeordnet sind,
- wobei der Stromrichter einen Lüfter (9) aufweist, der im zweiten Volumen (8) angeordnet ist und der eine Luftzirkulation im zweiten Volumen (8) bewirkt, und
- wobei ein mittels des Lüfters (9) erzeugter Luftstrom im Wesentlichen ausschließlich in das zweite Volumen (8) geführt wird, so dass eine Luftzirkulation im zweiten Volumen (8) größer ist als eine Luftzirkulation im ersten Volumen (7).

2. Stromrichter (1) nach Anspruch 1, **dadurch gekennzeichnet, dass**
- der Kühlkörper (3), das Gehäuse (4) und die erste Leiterplatte (2) derart geometrisch ausgestaltet sind, dass die Luftzirkulation im zweiten Volumen (8) größer ist, insbesondere mehr als 10 Mal größer ist, als eine Luftzirkulation im ersten Volumen (7).

3. Stromrichter (1) nach einem der vorhergehenden Ansprüche, **dadurch gekennzeichnet, dass**
- das Gehäuse derart ausgestaltet ist, dass der Lüfter (9) eine Luftzirkulation ausschließlich innerhalb des Gehäuses (4) bewirkt.

4. Stromrichter (1) nach einem der vorhergehenden Ansprüche, **dadurch gekennzeichnet, dass**
- der Lüfter (9) ein Axiallüfter ist, dessen Drehachse parallel zur ersten Leiterplatte (2) verläuft.

5. Stromrichter (1) nach einem der vorhergehenden Ansprüche, **dadurch gekennzeichnet, dass**
- der Stromrichter eine zweite Leiterplatte (10) aufweist, die planparallel zur ersten Leiterplatte (2) ausgerichtet ist.

6. Stromrichter (1) nach Anspruch 5, **dadurch gekennzeichnet, dass**
- der Stromrichter (1) ein Halteelement (12) aufweist, wobei das Halteelement (12) den Lüfter (9) und die zweite Leiterplatte (10) hält.

7. Stromrichter (1) nach Anspruch 6, **dadurch gekennzeichnet, dass**
- das Halteelement (12) derart geometrisch ausgestaltet ist, dass ein mittels des Lüfters (9) erzeugter Luftstrom in das zweite Volumen (8) geführt wird.

8. Stromrichter (1) nach einem der vorhergehenden Ansprüche, **dadurch gekennzeichnet, dass**
- der Kühlkörper (3) nur auf einer Seite, die dem wärmeerzeugenden Bauelement (5) abgewandt ist, Kühlrippen (13) aufweist.

9. Stromrichter (1) nach einem der vorhergehenden Ansprüche, **dadurch gekennzeichnet, dass**
- der Stromrichter (1) eine Schutzart gemäß IP 66 oder höher aufweist.

10. Stromrichter (1) nach einem der vorhergehenden Ansprüche, **dadurch gekennzeichnet, dass**
- der Stromrichter (1) eine Netzrückspeiseeinheit oder ein Frequenzumrichter ist.

## Claims

1. Power converter (1), comprising:
- a first printed circuit board (2),
- a heat sink (3),
- a housing (4), wherein the heat sink (3) and the housing (4) surround the first printed circuit board (2),
- a heat-generating component (5), which is arranged on a side (2a) of the first printed circuit board (2) facing the heat sink (3) and which is thermally conductively coupled to the heat sink (3), and
- further components (6), which are arranged on a side of the first printed circuit board (2) facing away from the heat sink (3),
- wherein the heat sink (3), the housing (4) and the first printed circuit board (2) delimit a first volume (7), in which the heat-generating component (5) is arranged,
- wherein the heat sink (3), the housing (4) and the first printed circuit board (2) delimit a second volume (8), in which the further components (6) are arranged,
- wherein the power converter has a fan (9), which is arranged in the second volume (8) and which causes a circulation of air in the second volume (8), and
- wherein an air flow generated by means of the fan (9) is guided substantially exclusively into the second volume (8), so that a circulation of air in the second volume (8) is greater than a circulation of air in the first volume (7).

2. Power converter (1) according to Claim 1,
**characterized in that**
- the heat sink (3), the housing (4) and the first printed circuit board (2) are geometrically designed in such a way that the circulation of air in the second volume (8) is greater, in particular more than 10 times greater, than a circulation of air in the first volume (7).

3. Power converter (1) according to either of the preceding claims, **characterized in that**
- the housing is designed in such a way that the fan (9) causes a circulation of air exclusively within the housing (4).

4. Power converter (1) according to either of the preceding claims, **characterized in that**
- the fan (9) is an axial fan, the rotation axis of which runs parallel to the first printed circuit board (2).

5. Power converter (1) according to either of the preceding claims, **characterized in that**
- the power converter has a second printed circuit board (10), which is oriented plane-parallel to the first printed circuit board (2).

6. Power converter (1) according to Claim 5,
**characterized in that**
- the power converter (1) has a holding element (12), wherein the holding element (12) holds the fan (9) and the second printed circuit board (10).

7. Power converter (1) according to Claim 6,
**characterized in that**
- the holding element (12) is geometrically designed in such a way that an air flow generated by means of the fan (9) is guided into the second volume (8).

8. Power converter (1) according to either of the preceding claims, **characterized in that**
- the heat sink (3) has cooling fins (13) only on a side facing away from the heat-generating component (5).

9. Power converter (1) according to either of the preceding claims, **characterized in that**
- the power converter (1) has a protection rating of IP 66 or higher.

10. Power converter (1) according to either of the preceding claims, **characterized in that**
- the power converter (1) is a regenerative power supply unit or a frequency converter.

## Revendications

1. Convertisseur électrique (1), comportant :
- une première carte de circuit imprimé (2),
- un corps de refroidissement (3),
- un boîtier (4), le corps de refroidissement (3) et le boîtier (4) entourant la première carte de circuit imprimé (2),
- un composant générant de la chaleur (5) qui est agencé sur un côté (2a) de la première carte de circuit imprimé (2) faisant face au corps de refroidissement (3) et qui est couplé au corps de refroidissement (3) de manière thermoconductrice, et
- d'autres composants (6) qui sont agencés sur un côté de la première carte de circuit imprimé (2) qui est tourné à l'opposé du corps de refroidissement (3),
- le corps de refroidissement (3), le boîtier (4) et la première carte de circuit imprimé (2) délimitant un premier volume (7) dans lequel le composant générant de la chaleur (5) est agencé,
- le corps de refroidissement (3), le boîtier (4) et la première carte de circuit imprimé (2) délimitant un second volume (8) dans lequel les autres composants (6) sont agencés,
- le convertisseur de puissance comportant un ventilateur (9) qui est disposé dans le second volume (8) et qui provoque une circulation d'air dans le second volume (8), et
- un flux d'air généré par le ventilateur (9) étant guidé sensiblement exclusivement dans le second volume (8), de sorte qu'une circulation d'air dans le second volume (8) est supérieure à une circulation d'air dans le premier volume (7).

2. Convertisseur électrique (1) selon la revendication 1, **caractérisé en ce que**
- le corps de refroidissement (3), le boîtier (4) et la première carte de circuit imprimé (2) sont conçus géométriquement de telle sorte que la circulation d'air dans le second volume (8) est plus élevée, en particulier plus de 10 fois plus élevée, qu'une circulation d'air dans le premier volume (7).

3. Convertisseur électrique (1) selon l'une des revendications précédentes, **caractérisé en ce que**
- le boîtier est conçu de telle sorte que le ventilateur (9) provoque une circulation d'air exclusivement à l'intérieur du boîtier (4).

4. Convertisseur électrique (1) selon l'une des revendications précédentes, **caractérisé en ce que**
- le ventilateur (9) est un ventilateur axial dont l'axe de rotation s'étend parallèlement à la première carte de circuit imprimé (2).

5. Convertisseur électrique (1) selon l'une des revendications précédentes, **caractérisé en ce que**
- le convertisseur électrique comporte une seconde carte de circuit imprimé (10) qui est orientée de manière plan-parallèle à la première carte de circuit imprimé (2).

6. Convertisseur électrique (1) selon la revendication 5, **caractérisé en ce que**
- le convertisseur électrique (1) comporte un élément de maintien (12), l'élément de maintien (12) maintenant le ventilateur (9) et la seconde carte de circuit imprimé (10).

7. Convertisseur électrique (1) selon la revendication 6, **caractérisé en ce que**
- l'élément de maintien (12) est conçu géométriquement de telle sorte qu'un flux d'air généré par le ventilateur (9) est guidé dans le second volume (8).

8. Convertisseur électrique (1) selon l'une des revendications précédentes, **caractérisé en ce que**
- le corps de refroidissement (3) comporte des ailettes de refroidissement (13) uniquement sur un côté qui est tourné à l'opposé du composant générant de la chaleur (5).

9. Convertisseur électrique (1) selon l'une des revendications précédentes, **caractérisé en ce que**
- le convertisseur électrique (1) présente un indice de protection selon IP 66 ou supérieur.

10. Convertisseur électrique (1) selon l'une des revendications précédentes, **caractérisé en ce que**
- le convertisseur électrique (1) est une unité de réinjection réseau ou un convertisseur de fréquence.
